Europäisches Patentamt

European Patent Office

Office européen des brevets

(19)

(11) Publication number: **0 297 418**
**A1**

# EUROPEAN PATENT APPLICATION

(12)

(21) Application number: 88109961.8

(51) Int. Cl.⁴: **G01R 23/15**

(22) Date of filing: **23.06.88**

(30) Priority: **29.06.87 SE 8702683**

(43) Date of publication of application:
**04.01.89 Bulletin 89/01**

(84) Designated Contracting States:
**CH DE ES FR GB IT LI NL**

(71) Applicant: **ASEA BROWN BOVERI AB**

**S-721 83 Västeras(SE)**

(72) Inventor: **Bergman, Sten**
**Östanvindsgatan 11**
**S-723 48 Västeras(SE)**
Inventor: **Ljung, Stefan**
**Violstigen 4 B**
**S-722 27 Västeras(SE)**

(74) Representative: **Boecker, Joachim, Dr.-Ing.**
**Rathenauplatz 2-8**
**D-6000 Frankfurt a.M. 1(DE)**

(54) **Method for operating a frequency relay and frequency relay for carrying out the method.**

(57) Method for operating a frequency relay and frequency relay for carrying out the method which, via measuring transformers, senses the frequency of an electric power network, determines the value of the frequency and delivers an output signal when the frequency thus determined drifts out of a permissible frequency range. Specific to the invention is the method of determining the currently prevailing frequency of the power network. The measurement signal $(\hat{y}(t))$ obtained from the network is transformed, after filtering (1) and digitizing (2), into an analytic model (4) in the form of a truncated Fourier series (y(t)), the coefficients of which are determined in a parameter estimator (3) which operates with a method of estimation (5) in accordance with the least squares method. Starting from model values, according to the invention a computation of the frequency can be carried out in a frequency estimator (6), the output signal of which, on the one hand, is returned as current frequency value to the parameter estimator and, on the other hand, constitutes a measure of the current frequency $(\hat{\omega})$ when determining the limits of permissible frequency variations.

FIG. 1

## Method for operating a frequency relay and frequency relay for carrying out the method

The invention relates to a method for operating a frequency relay according to the precharacterising part of Claim 1. The invention also relates to a frequency relay for carrying out the method.

Frequency relays are used in a plurality of protective functions in fields like electric power distribution or power transformation. Purely generally, it can be said that the duty of such protective devices is to initiate actions via frequency relays which prevent any harmful effect of a frequency change (rise or reduction) going beyond certain predetermined limit values in relation to the nominal frequency of the power network in question.

If, in the event of faults of various kinds, large power generating units (generators or power plants) are tripped, the remaining power generation capacity may become smaller than the actual load. This results in a frequency drop in the network which may grow to such an extent that other gen erators in the network can no longer function. These will then be tripped by their respective under-frequency protection devices.

An under-frequency protection device is also used to protect the turbine wheels in steam turbines against too low a speed. In the event of a fault on a turbine governor, an over-frequency protection device can influence the stop valve of the turbine and hence prevent the turbine from running at too high speeds.

A frequency protection device can also be used to monitor the speed of synchronous motors and rotating reactive power compensators.

An important object in connection with frequency relays is to determine the currently prevailing frequency of the monitored network. Characteristic of the prior art methods for frequency determination is that they are based on measuring the distance between the zero crossings of the alternating measurement signal. However, these methods do not take into account the fact that the mean value of the measurement signal may be different from zero, which is true above all in connection with and immediately after large abrupt changes of the operating conditions of the network. A consequence of this is that the frequency is not determined or estimated as accurately as would be of interest in many applications.

The technique of determining the frequency of a network with the aid of the zero crossings of the measurement signal has been realized both using classical analog technique and modern numerical technique.

The analog technique comprises several different embodiments. Since the frequency determination according to the invention deals with the application of numerical technique, the classical, analog methods will be described very briefly and schematically.

In an analog method, a comparison is made between the phase position of the current in an LC circuit, the resonance frequency of which is to correspond to the expected frequency of the network, for example 50 Hz, and the phase position of the current in a purely resistive circuit. Another principle of measurement is based on a quartz-controlled oscillator. The number of pulses from the oscillator is counted during each cycle or half-cycle of the mains voltage and is compared with a reference level which is set for the frequency value. A further analog principle is described in SE-A-333 969 entitled "Means for measuring the frequency difference between two alternating voltages". In this case, saturable reactors are used as frequency sensing elements.

For the analog technique to operate satisfactorily, normally several rows of filters must be used, and the frequency is usually determined by forming a mean value over several cycles. In case of abrupt changes of the frequency, a decaying direct voltage component and noise are normally imparted to the measured signal. Since the technique is, in principle, based on undisturbed signals, the frequency determination will not be as accurate as is desirable. Otherwise, the use of analog components involves trimming and drift problems which are not present in numerical processing.

Characteristic of the application of numerical technique to the frequency determination is that the measurement signal is regarded as a stochastic process and that an analytical model thereof is formed. The numerical technique permits the use of statistical methods for the signal processing, which results in the following advantages: a good noise reduction; a faster good quality measurement result; freedom from aging and calibration; no drift problems.

In the same way as the analog technique can be carried out in many different ways, there are at present several different ways of carrying out frequency determination using numerical technique. Characteristic of these, however, is that - in the same way as the analog technique - they are based on measuring the distance between the zero crossings of the measurement signal. In exactly the same way as for the analog solutions, especially in case of abrupt changes where the mean value of the signal is different from zero, this means a certain inaccuracy in the frequency determination.

Numerical technique applied in this connection is described in a number of publications and patents, inter alia, in M.S. Sachdev and M.M. Giray, "A Least Error Squares Technique for Determining Power Systems Frequency", IEEE Trans. on Power Apparatus and Systems, Vol. PAS -104, No. 2, February 1985, pages 437-444. The limitations of the described method originate from the assumption that the signal has only a fundamental frequency and that only the frequencies which lie in the immediate vicinity of the fundamental frequency are studied. Around this frequency the model is approximated by using Taylor series expansions of the trigonometric expressions. A consequence of this is that the accuracy in the frequency estimation will be reduced as the actual frequency becomes gradually different from the fundamental frequency.

Otherwise, Sachdev et al make use of the least squares method, which is based on estimating relevant parameters with signal values obtained from a finite time window. In this way the pseudo-inverse is formed, which is a "heavy" process from the computational point of view.

Frequency determination using numerical techniques based on measurement of the distance between the zero crossings of the signal, but using a different technique from that described in the Sachdev et al article, is clear from, inter alia, A.A. Girgis and R.G. Brown, "Application of Kalman Filtering in Computer Relaying", IEEE Trans. on Power Apparatus and Systems, Vol. PAS -100, No. 7, July 1981, pages 3387-3397, and from A.A. Girgis, "A new Kalman Filtering Based Digital Distance Relay", IEEE Tran. on Power Apparatus and Systems, Vol. -101, No. 9, September 1982, pages 3471-3480.

Concepts from the signal theory, modelling of dynamic systems and numerical analysis have long been used within modern feedback control technique to be able to calculate large and complicated process control systems. To a certain extent these concepts have also started being used in connection with frequency determination in frequency relays. The model in this connection often consists of a truncated Fourier series expansion of the monitored signal. In the above-mentioned publications by Girgis as well as in US-PS-4,455,612 entitled "Recursive Estimation in Digital Distance Relaying System", recursive Kalman filter technique is applied to estimate the unknown parameters of the model. Similar methods have been used in the previously mentioned article by Sachdev et al and in an article by A.G. Phadke, J.S. Thorp and M.G. Adamiak, "A New Measurement Technique for Tracking Voltage Phasors, Local System Frequency, and Rate of Change of Frequency", IEEE Tran. on Power Apparatus and Systems, Vol. PAS -102, No. 5, May 1983, pages 1025-1038.

Especially the latter publications deal with investigations in which adaptive parameter estimation techniques are applied. These techniques work with estimating the parameters over a sliding, fixed time window, as also mentioned above, and with the pseudo-inverse used to solve the linear equation system which defines the parameters of the model, for example the Fourier coefficients.

The publication "Theory and Practice of Recursive Identification, by L. Ljung and T. Söderström, Cambridge, Mass., MIT Press, 1983, pages 323-327, describes a method in which parameter adaptation is recursively applied at each sampling instant with the aid of an exponential, so-called forgetting factor. The object of the method described there is to weigh together old information with an exponentially diminishing measure. In this way slow changes are treated. This publication also investigates algorithms for adaptive systems with respect to rapidity, convergence and numerical accuracy.

An abrupt change of the measurement signal unavoidably leads to major changes of the parameters. For that reason, methods which take care of rapid changes must also be coupled together with the parameter estimation, which is otherwise, pure generally, performed in a so-called parameter estimator, to determine when an event has occurred in the studied signal. The methods therefore are also described in the Ljung and Söderström publication, pages 54-60.

The prior art comprising the normally used Fourier model, which will be described in greater detail, assumes that the frequency of the studied signal is known with great accuracy, and when studying the mains frequency it is assumed that the frequency is 50 Hz or 60 Hz. If this is not the case, the parameters in the parameter estimation algorithm will vary periodically with a frequency which is equal to the difference in frequency between the frequency in the model and the actual system frequency, which will therefore also be true of the estimation errors (see text below) for the studied signal. The amplitude of the oscillation is also dependent on the frequency difference. This will, of course, entail problems since the model will then oscillate because the frequency of the measurement signal, the variation of which is to be measured, deviates from the nominal frequency.

The model technique and the recursive estimation technique, which will now be described in more detail, is a summary of the prior art which has been used individually in various applications. The description and the mathematical expressions and algorithms utilized can be regarded as a concentrate of necessary information obtained, for example, from the Ljung and Söderström publication, which is needed to realize the invention (see pages 321-369).

If the signal which is to be processed is harmonic with the frequency $f_0$, i.e. can be expressed as

$$y\left(t + \frac{1}{f_0}\right) = y(t) \qquad (1)$$

In this case a suitable model of the signal is a truncated Fourier series. This is applicable since voltages and currents in a power line system are normally cyclical in stationary state. Also a possible transient phase can then be modelled in the same way with sufficient accuracy by assuming that the mean value of the signal curve exhibits an exponentially decreasing shape after a fault. The following relation for the model is thus valid:

$$y(t) = a_0 \exp(-b_0 t) + \sum_1^N c_j \sin(\omega_j + d_j) \qquad (2)$$

This expression is well-known from many applications and, therefore, a description of the quantities and parameters included is not necessary.

Theoretically, N, i.e. the number of terms in the truncated Fourier series, may assume arbitrarily large values. Because of the necessity to keep the amount of computation work below a moderate level during real-time implementation, N is normally limited so that only the fundamental tone and the first harmonic components are included in the processing.

The accuracy of the estimated parameters is, of course, dependent on the truncation of the Fourier series and hence also on the adaptation thereof to the signal. As will be clear from the further description, it is also very important that the signal is allowed to pass through an analog filter before the A/D (analog-to-digital) conversion is accomplished.

Since the mathematical notation in connection with signal theory and recursive technique differs from the conventional mathematical notation, a few examples will be given to facilitate the reading of the following description.

If $\theta$ constitutes a column vector. $\theta^T$ means the same vector in row form, i.e. the transpose of $\theta$.

If $\theta$ means a true measured value of a vector. then $\hat{\theta}$ means an estimated value of the same vector.

By "arg" prefixed to a vector function is generally meant an arbitrary vector in the definition set of the function. By "arg min" is thus meant that vector which gives the vector function a minimum.

According to current technology, the model equation for the curve shape of the signal according to equation (2) can be transformed to

$y(t) = \theta^T \phi(t) \qquad (3)$

where $\theta_T$ represents a vector in row form for estimation of the parameters included in equation (2), i.e.

$\theta^T = (a_0, -c_0 b_0, c_1 \cos d_1, c_1 \sin d_1, ... c_N \cos d_N, c_N \sin d_N) \qquad (4)$

and $\phi(t)$ consists of a regressive vector

$\phi(t) = (1, t, \sin \omega_0 t, \cos \omega_0 t, ... \sin N_0 \omega_0 t, \cos N_0 \omega_0 t) \qquad (5)$

The parameter vector $\theta$ thus contains elements which provide information about the system whereas $\phi(t)$ comprises the regressors which generate the output signal from the model.

The equations (4) and (5) describe a general model in the sense that they do not require any special knowledge of the system save for the periodic structure. As will be clear from equation (5), the elements of the regressive vector must be calculated new at each sampling instant. Such a structure can be used in the application of the estimation algorithm which will be described below. From (4) it is also clear that the following relationships apply between the elements in the $\theta$-vector and amplitude ($c_i$) and phase ($d_i$) in the different Fourier components

$c_j = (\theta_{2j-1}^2 + \theta_{2j}^2)^{1/2} \qquad (6)$

$d_j = \arg(\theta_{2j-1}^2, \theta_{2j}) \qquad (7)$

The determination of the system parameters - the parameter estimation - from successively measured values of y(t) according to equation (3) is usually carried out according to the least squares method. This means that the parameters are chosen to minimize the value of a so-called "loss function" $V_N$. $V_N$ is defined as follows:

$$V_N(\lambda, t) = \sum_{j=1}^t \lambda^{t-j} \varepsilon^2(j) = \lambda V_N(\lambda, t-1) + \varepsilon^2(t) \qquad (8)$$

The function includes a so-called forgetting factor $\lambda$, which in this connection is a constant, and where $\epsilon(t)$ is an estimation error function, i.e. $\epsilon(t) = y(t) - \hat{y}(t)$.

The general solution to this equation is given by the estimated value $\hat{\theta}(t) = \arg \min \{V_N(\lambda, t)\} \qquad (9)$

4

By differentiating $V_N$ with respect to the parameter vector, which is implicitly included in $\epsilon(t)$, the following equation (10) is obtained for calculating $\theta(t)$ which can be solved as soon as the number of sampling points exceeds the number of estimated parameters:

$$\Theta(t) = \left[ \lambda^{t-1}(0) + \sum_{j=1}^{t} \lambda^{t-j} \varphi(j) \varphi^{T}(j) \right]^{-1} \left[ \sum_{j=1}^{t} \lambda^{t-j} \varphi(j) Y(j) \right] \quad (10)$$

P(0) is equal to the initial value of the covariance matrix of the parameter vector (see latter part of the description). For each new updating of the estimated value $\hat{\theta}(t)$, a number of samples are required which are equal to or greater than the number of elements in the $\theta$-vector ($N \geq \dim \theta$). This also means that at least N values must be sampled before the first estimation can be made unless $p^{-1}(0) \neq 0$.

The estimation of the parameters according to equation (10) can be performed recursively with the aid of the following algorithm which comprises:

$R(t) = \lambda R(t-1) + \phi(t) \phi^{T}(t) \quad (11)$

$R(0) = \delta \cdot I \quad (12)$

$R(t) L(t) = \phi(t) \quad (13)$

$\hat{y}(t) = \hat{\theta}^{T}(t-1) \phi(t) \quad (14)$

$\epsilon(t) = y(t) - \hat{y}(t) \quad (15)$

$\hat{\theta}(t) = \hat{\theta}(t-1) + L(t) \epsilon(t) \quad (16)$

In addition to the previously defined quantities, R(t) here designates the covariance matrix of the regressive vector, $\delta$ its initial parameter, and I a unit matrix. L(t) is a gain vector which is defined according to (13) and (19) below. This algorithm contains the solution of a linear equation system which shows that the number of arithmetical operations is proportional to $N^3$. For real-time implementation, it is therefore more advantageous to utilize the low rank structure in equation (11) for a recursive real-time algorithm. By applying the matrix inversion lemma to equation (11), an updating of the inverse of R(t) can be obtained, i.e. $P(t) = R^{-1}(t)$, whereby, in accordance with known recursive formulae, the following relationships apply:

$r(t) = P(t-1) \phi(t) \quad (17)$

$d(t) = \lambda + \phi^{T}(t) r(t) \quad (18)$

$L(t) = r(t)/d(t) \quad (19)$

$P(t) = [P(t-1) - r(t) L^{T}(t)] \lambda \quad (20)$

$P(0) = (1 \cdot \delta) \cdot I \quad (21)$

$\theta(0) = \theta_0 \quad (22)$

where d(t) and r(t) denote necessary auxiliary functions.

The implementation of the algorithm can be carried out in a simple manner since it is exclusively based on matrix and vector calculations. The parameter $\delta$ is chosen sufficiently small to avoid problems with singular matrices and to enable a rapid adaptation immediately after an initialization. The choice of $\theta_0$ can either be made arbitrarily, for example all components equal to zero, or empirical model values can be used initially until the updating of the covariance matrix has become stabilized.

For high dimensions of the regressive vector, numerical inaccuracy may cause serious problems. Also a limited word length or number of elements tend to have an undesirable effect on the solution; it may, for example, become unstable or assume infinite values. Because of these facts it is usually not possible to carry out a direct implementation of the equations (17) ... (22). A more appropriate method is then to base the solution on an algorithm which is based on square root decomposition of P(t). Such a method is described by G.J. Bierman in "Factorization Methods for Discrete Sequential Estimation", Academic Press, New York (1976), pages 44-47. Since P(t) is updated by a low rank structure from P(t-1), it is possible to update the U(t) and D(t) components described in Bierman's publication in accordance with a special algorithm mentioned there which reduces the number of numerical operations. This method makes it possible to attain the same time complexity as for the conventional algorithm according to equations (17) ... (22). For this invention and application, the UD-based algorithm has been investigated with respect to numerical accuracy and has proven to be exponentially convergent, which shows that the effects of faults introduced into the algorithm, for example as a result of implementation with a curtailed word length, tend to decay in proportion to the forgetting factor. The point of convergence is, of course, dependent on the current number representation.

The invention aims at developing a method for operating a frequency relay which enables a highly accurate, constantly updated and fast determination of the frequency of the input signal which is also accurate under abrupt transient conditions in the monitored power network.

To achieve this aim the invention suggests a method for operating a frequency relay according to the introductory part of Claim 1, which is characterized by the features of the characterizing part of Claim 1.

Further developments of the method according to the invention are characterized by the features of the additional Claims 2 and 3.

A frequency relay for carrying out the method according to the invention is characterized by the features of Claim 4.

The external functions of a frequency relay according to the invention are the same as those according to the state of the art. Specific to the relay, however, is the manner in which the determination of the frequency in question is carried out, namely, using digital technique and microprocessors. This means that the frequency measurement as such can be integrated with and be used in other types of modern protective relays which require accurate knowledge of the current frequencies of the network. This applies, for example, to fault locators and distance protection means of various kinds, the function of which is dependent on microprocessors included in the protection device, and the programming, structural build-up, etc., of such microprocessors.

Immediately after an initialization of the parameter estimation algorithm, the recursion of the covariance matrix is sensitive to noise. This effect becomes still more pronounced for small values of $\lambda$. As an immediate consequence of this property, it is possible to find a remedy by applying a time-dependent forgetting factor, which is initially equal to a lower value, $\lambda_o$, and which thereafter converges towards a predetermined value $\lambda\infty$ i.e.

$$\lambda(t+1) = \zeta\lambda(t) + (1-\zeta)\lambda\infty \qquad (23)$$
$$\lambda(0) = \lambda_o \qquad (24)$$
$$\lambda(\infty) = \lambda\infty \qquad (25)$$

where $\zeta$ is a measure of the rate of convergence towards $\lambda\infty$. As usual, suitable choices of $\lambda_o$ and $\lambda\infty$ are given by $\lambda_o\epsilon[0.9,1.0]$ and $\zeta\epsilon[0.9,1.0]$, respectively. With this technique, a fast convergence as well as good numerical properties in cases involving sensitive signals are obtained.

Otherwise, since in accordance with the prior art, data from a limited time window have been utilized, an equation system must be solved at each sampling instant or at least when a new estimation of the frequency is desired. This is eliminated by algorithms (17) ... (22).

The invention will now be described in greater detail with reference to the accompanying drawings showing - by way of example - in

Figure 1 a fundamental structure of the frequency determination in a frequency relay according to the invention,

Figure 2 a somewhat more detailed fundamental structure of the frequency determination in a frequency relay according to the invention,

Figure 3 a flow chart for the frequency estimator included in the invention.

Figure 4 the sequence of calculations in the parameter estimator included in the invention,

Figure 5 a structure of a frequency relay according to the invention.

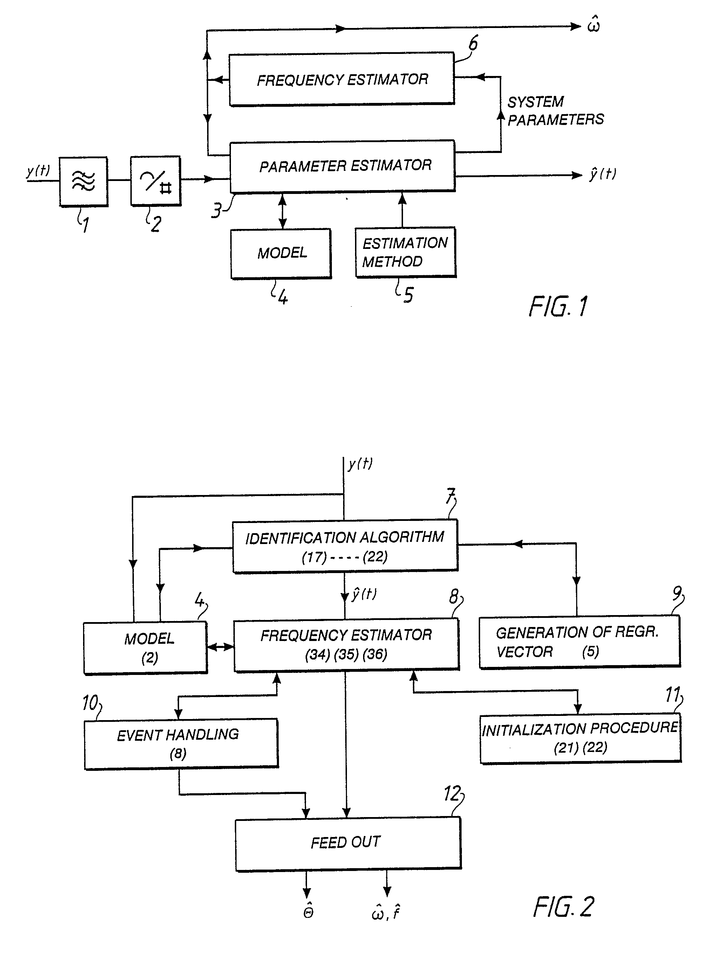

The principle of the frequency determination according to the invention is clear from Figure 1. To a certain extent, as also described above, it comprises aspects of the prior art applied in other contexts and aspects of new and unique technique.

The measurement signal y(t) passes through an analog filter 1 and is sampled or converted to digital representation by an analog-to-digital converter 2. The digitized signal is passed to a parameter estimator 3 which has at its disposal a model 4 comprising a structure for forming a model of the measurement signal, and an estimation unit 5 comprising the structure for the estimation methodology included therein.

As will have been clear, several different models are available, for example a Taylor series expansion of the measurement signal according to Sachdev et al. or a Fourier series expansion, possibly with an exponential mean value according to (2). The model used in this connection is based on a Fourier expansion of the signal.

As will also have been clear from the above description, several models are available for estimating the system parameters or the coefficients in the applied model. The Taylor series expansion of the measurement signal according to Sachdev et al makes use of a least squares method for determining the parameters. In the Girgis publications mentioned above, a technique is used which is based on Kalman filtering.

In an application according to the invention, the combination of Fourier series expansion and recursive least squares method is used to determine the coefficients of the Fourier series.

This makes it possible, with the aid of the parameter estimator, the model and the estimation methodology, to obtain an estimated, filtered measurement signal $\hat{y}(t)$ expressed in accordance with the analytical expression of the model.

As will have been clear from the above, according to current technology an assumption is made as regards the frequency and if the frequency of the measurement signal deviates from this assumption, the system parameters and hence the residual function $\epsilon(t)$ will oscillate with the differential frequency and also the amplitudes of the residual functions tend to oscillate with the same frequency. If the frequency could be estimated and fed into the parameter estimator and the model, this oscillating drawback could be eliminated. A condition for this, however, is that the frequency estimation is accurate.

The method which is comprised by the invention permits an exact calculation of the frequency of the measurement signal based on sampled values of the estimated measurement signal, i.e. of $\hat{y}(t)$. This calculation, which is accomplished in a frequency estimator 6, is continuously updated. By feeding back the estimated frequency to the parameter estimator and the model, in accordance with elementary feedback control technique, the parameter estimator will, after a first frequency assumption, work with the current frequency. In consequence thereof, also the output signal of the frequency estimator constitutes an estimated value which with great accuracy shows the current frequency of the measured signal.

The invention entails that the Fourier components and the exponential term are updated recursively starting from the immediately preceding estimation. This means that the computational work is considerably reduced, which therefore also means that the sampling time can be chosen shorter. The system is built up with a fixed number of sampling instants per cycle. The distance between the nodal points is changed as soon as a major change of the frequency has been observed.

Since the computation as such can be regarded as a digital filter, no additional software filtering is needed.

The method according to the invention permits the mean value of the measurement signal to be estimated after the occurrence of a fault. A consequence of this is that exponentially decaying transients will be under control and that reliable estimations of the frequency can be obtained more rapidly. The number of estimations per cycle is S-2 if S denotes the number of sampling instants during one cycle. The intensity of estimations will thus be considerably higher with maintained accuracy.

The need to have knowledge of transients and stationary frequencies is also present in other fields where protective relays are used, for example in distance protection devices. Since knowledge of both of the above properties is available in the method according to the invention, this knowledge can be advantageously applied directly to distance protection devices as well.

In the following a calculation of the frequency of the filtered and modeled measurement signal is described:

If it is assumed that the processed measurement signal can be modelled in accordance with equation (2), the stationarily periodic fundamental component of the signal can be extracted by studying

$$y_e(t) = a \cdot \sin\omega t \quad (26)$$

This model contains three unknown quantities, namely amplitude a, angular frequency $\omega$ and running time t. By sampling three consecutive values $y_1$, $y_2$, $y_3$ from the model, which are separated by the distance h in time, it is possible to estimate a and $\omega$ according to the following technique. From equation (26) is is clear that the sampled values can be expressed as $y_1 = y_e(t-h) = a \cdot (\sin(\omega t) \cdot \cos(\omega h) - \cos(\omega t) \cdot \sin(\omega h))$ (27a)

$$y_2 = y_e(t) \quad (27b)$$

$$y_3 = y_e(t+h) = a \cdot (\sin(\omega t) \cdot \cos(\omega h) + \cos(\omega t) \cdot \sin(\omega h)) \quad (27c)$$

By introducing $b = a^2$ and applying straightforward trigonometric relationships, $y_1$ and $y_3$ can be developed further by substituting $y_2$ as follows

$$y_1 = y_2\cos(\omega h) + (b-y_2^2)^{1/2} \sin(\omega h) \quad (28a)$$

$$y_3 = y_2\cos(\omega h) - (b-y_2^2)^{1/2} \sin(\omega h) \quad (28b)$$

or in a more concentrated form

$$y_1 = -a \cdot \sin(\omega h - \phi) \quad (29a)$$

$$y_3 = a \cdot \sin(\omega h - \phi) \quad (29b)$$

$$\phi = \text{arc } \sin(y_2/a) \quad (29c)$$

If equation (28) is solved with respect to $\sin(\omega h)$, the following is obtained

$$\sin(\omega h) = b^{-1}(y_2(b-y_1^2)^{1/2} - y_1(b-y_2^2)^{1/2}) \quad (30a)$$

$$\sin(\omega h) = b^{-1}(y_3(b-y_2^2)^{1/2} - y_2(b-y_3^2)^{1/2}) \quad (30b)$$

By introducing $x = \sin(\omega h)$ and manipulating equations (30a) and (30b), the following is obtained

$$(y_1+y_3)(b-y_2^2)^{1/2} = y_2((b-y_3^2)^{1/2} + (b-y_1^2)^{1/2}) \quad (30c)$$

The equation only contains one unknown variable, namely b. By continued proceeding, the square roots can be eliminated and the final expression, which is quadratic in b, is given as

$$b\left(\left(\left(\left(y_1+y_3\right)^2-2y_2^2\right)^2-4y_2^4\right)b+4y_2^2\left(y_1y_2\left(y_2+y_1\right)-2y_2^2\right)-\left(y_3^2+y_1^2\right)y_2^2\right)=0 \quad (31)$$

Equation (31) has two solutions. One is zero and the other is given by

$$b = \frac{4y_2^2(y_1y_3-y_2^2)}{(y_1+y_3)^2-4y_2^2} = \left[\frac{4y_2}{y_1+2y_2+y_3}\right] \cdot \left[\frac{y_1y_3-y_2^2}{y_1-2y_2+y_3}\right] \cdot y_2 \quad (32)$$

The last equality in (32) is favourable if the signal can assume large values. Equation (32) is now to be interpreted as an estimation of the square of the amplitude.

By setting $z = (30a) = (30b)$     (33)

and by introducing in this auxiliary function a computed value of b according to (32), the following estimation of the unknown angular frequency is obtained

$x = h^{-1}$ arc $\sin(z)$     (34)

The initial parameters to compute the angular frequency are $y_1$, $y_2$, $y_3$ and b. Since the filtered amplitude of the signal can be obtained from the parameter estimation algorithm, the computation of b in (32) can be eliminated. This means that only the frequency computation according to (34) need be added to the original estimation process.

The described technique utilizes information from three sampled values only. This means that stringent demands must be imposed on the analog filter which precedes the estimator. A better method should therefore be to consider a sequence of measured values ($y_j$, $j = 1$:N) and to successively compute estimations of the angular frequency in accordance with

$x_n = b_n^{-1} \quad (y_n(b_n-y_{n-1}^2)^{1/2} - y_{n-1}(b_n-y_n^2)^{1/2})$     (35)

It is assumed here that $b_n$ is obtained from the parameter estimator. It is clear from equation (35) that only one square root need be computed if $|b_n-b|<\eta$ for some small number $\eta$.

To prevent too great deviations from the true value, a sliding mean value is used as the final estimation, $\hat{\omega}(t)$, of the angular frequency

$\hat{\omega}(t) = \mu \cdot \omega(t-1) + (1-\mu) \cdot x(t)$     (36)

The filter parameter $\mu$ is chosen here in the same interval as the previously described forgetting factor $\lambda$. To obtain a robust estimation, one additional precautionary measure should be taken. If the estimation of the frequency computed at a given sampling instant differs too much, for example by p%, from the running mean value, it should be omitted. It is also advantageous to omit such estimations which deviate sufficiently from the immediately preceding one. To limit the number of incorrect values, the filtered values are used in place of the instantaneous ones.

The method described requires an accurate, analog pre-filtering of the measured signal values in order not to render the frequency estimation too inaccurate. In addition, the number of overlooked estimations must be kept at a limited level if the studied signal is regular.

From equation (28) it is possible to derive the following expression for computation of the angular frequency, given three consecutive sample values of the proceeded signal

$$\omega = h^{-1} \text{ arc } \cos \frac{y_1+y_3}{2y_2} \quad (37)$$

which can also be expressed as

$\hat{\omega} = h^{-1}$ [arc $\sin(y_3 \cdot a)$ - arc $\sin(y_2 \cdot a)$] $= h^{-1}$ (arc $\sin$ [$b^{-1}(y_3(b-y_2^2)^{1/2} - y_2(b-y_3^2)^{1/2})$])     (38)

To calculate $\omega$ according to these relationships, however, trigonometric expressions must be developed. For this reason, it is advantageous to derive a method which reduces the number of mathematical functions to be evaluated. Such an equation is provided by (35).

The signal model used in equation (26) is limited to the special case where $\phi = 0$. However, this is not a serious restriction since the phase angle is a relative quantity which is only of significance in cases where more than one signal is considered. In other cases the omission of the phase angle in the model should not influence the frequency estimation other than during the transient phase. By taking the phase angle into

8

account, the algorithm can be extended to be applicable also to the estimation of the relative phase distance between different signals. On the other hand, this information is already available in the Fourier model. In order to make the representation complete, also the extended algorithm is presented here.

Let the signal model be represented by (2) and define $y_2$ as

$$y_e(t) = \hat{y}(t) - \hat{a}_0 e^{-1\frac{t}{\tau}} \quad (39)$$

Contrary to the previous case, the function in equation (36) is developed at four consecutive sampling instants $t_1-h$, $t_1$, $t_1+h$ and $t_1+2h$ to gain knowledge of the phase shift $\phi$. By analogy with (30) the following is obtained:

$$\sin(\omega h + \phi) = b^{-1}(y_2(b-y_1^2)^{1/2} - y_1(b-y_2^2)^{1/2}) \quad (40a$$

$$\sin(\omega h + \phi) = b^{-1}(y_3(b-y_2^2)^{1/2} - y_2(b-y_3^2)^{1/2}) \quad (40b)$$

$$\sin(\omega h + \phi) = b^{-1})y_4(b-y_3^2)^{1/2} - y_3(b-y_4^2)^{1/2}) \quad (40c)$$

From equations (39) and (40) the amplitude and the argument $\omega h + \phi$ can be estimated with an analog technique which has been described above, that is to say,

$$\sin(\omega + \phi) = c \quad (41a)$$

$$\sin(2\omega h + \phi) = \sin(\omega h - \phi)\cos(\omega h) + \cos(\omega h + \phi)\sin(\omega h) = d \quad (41b)$$

A combination of the expressions in (41) gives

$$c \cdot \cos(\omega h) + (1-c^2)^{1.2} \sin\omega h = d \quad (42)$$

Simple trigonometric relationships make it possible to represent (41) in the more succinct form

$$\sin(\omega h + \alpha) = d \quad (43a)$$

$$\sin(\alpha) = c \quad (43b)$$

This means that the angular frequency can be estimated with the aid of the following relationship $\hat{\omega} = h^{-1}(\text{arc sin}(d) - \text{arc sin}(c)) \quad (44)$

and in this way an estimation of the phase angle can be obtained as

$$\hat{\phi} = \text{arc sin}(c) - \hat{\omega}h = 2\text{arc sin}(c) - \text{arc sin}(d) \quad (45)$$

By using (41) the variables c and d can be expressed as a function of the sampled values according to

$$c = \hat{b}^{-1}(y_2(\hat{b}-y_1^2)^{1.2} - y_1(\hat{b}-y_2^2)^{1/2}) \quad (46a)$$

$$d = \hat{b}^{-1}(y_4(\hat{b}-y_3^2)^{1/2} - y_3(\hat{b}-y_4^2)^{1/2}) \quad (46b)$$

Depending on the system to which the estimator is to be applied, it may be necessary to study further expansions of the algorithm (44). After a fault the mean value is initially different from zero and it will decrease exponentially towards zero according to equation (2). Also when an extra signal source has been connected, the mean value is different from zero. In the latter case the mean value remains different from zero even after the transient phase, which means that it is necessary to estimate it. However, the mean value is estimated in the main algorithm, as has been described previously. By taking this into account, the frequency estimator can be applied to oscillating signals which are superimposed on the mean value. From this fact the conclusion may be drawn that it is advantageous to apply one frequency estimator for each phase.

In the following the technical basis for frequency determining embodiments will be described:

It is clear from equations (31), (34) and (36) that it is necessary upon each updating of the frequency estimation to carry out the following operations: (additions/subtractions, multiplications, divisions, taking of square roots) = (4,7,1,2). The square roots can be determined either by us ing the Newton-Raphson algorithm, or by carrying out a linear interpolation in a pre-computed table. In the former case the maximum number of operations will be (a,m,d) = (10,10,10). This corresponds to 5 iterations, which is an acceptable number if the initial solution is sufficiently good. To obtain as good an algorithm as possible with a minimum number of iterations, it may be advantageous to scale the argument so that it lies in the interval (1,10). This means that $10^{1/2}$ and $0.1^{1/2}$ must be pre-computed and saved for subsequent treatment of the argument if it has been scaled. The total number of arithmetical operations for an updating, with the exception of scaling, will thus be (a,m,d) = (24,27,21). If a TMS32010 is used as processor during the implementation, the time of execution will be $(24+27+21 \cdot 4) \cdot 3\mu s = 405\mu s$. This consideration assumes that a division takes 4 times as long as a multiplication. A few additional operations must be carried out during the scaling, which means that 0.5 ms is a likely time of execution for one estimator. It should also be considered that one parameter estimator for each phase is required. On the other hand, it is sufficient with only one frequency estimator. The shortest sampling time will therefore not exceed 1 ms. From this follows that 20 samples per cycle can be carried out, that is to say, 19 independent estimations can be carried out. This is not too short a sampling time for the estimator, since the changes in the fundamental frequency are mostly rather small, i.e. ± 1 Hz/s. A faster estimation procedure can be obtained by linear interpolation in a square root table where the nodal points of the argument are equally spaced.

A very important matter when implementing the frequency estimator is to reduce the number of operations as much as possible. It is also necessary to apply such algorithms that are convergent and

EP 0 297 418 A1

robust so that they can be implemented with a short word length. The time of execution for one it eration of the algorithm depends essentially on the following factors: 1) the number of estimated parameters, 2) the word length in question, 3) the algorithms in question, 4) the cycle time of the microprocessor, 5) the implementation of the algorithm, for example several parallel activities if possible, and 6) rendering the algorithm discrete during the numerical processing. Also the accuracy is dependent on some of the listed points. In addition, the correspondence in appearance between the model and the real system plays a decisive role.

It is clear from equations (17) ... (22) that if $\lambda$ and $\omega$ assume constant values, the gain vector L(t) will stationarily only depend on these parameters. This means that the L(t) vector can be pre-computed as a first step before the parameter estimation algorithm is initialized. From this follows that the number of operations is reduced from being quadratically dependent on N, i.e. the number of terms in the truncated model, to being linearly dependent on N. On the other hand, the need for data memory is at the same time increased. If $\lambda$ and $\omega$ are limited to a finite number of discrete values, the data memory can be kept at a low level. In actual fact, the forgetting factor can normally be maintained constant during the whole execution instead of prescribing a time dependence or values which are pointwise constant. Since there are rigorous demands to keep the frequency within a small interval around the nominal frequency, only a limited amount of $\omega$-values will be of interest. If the set of possible values lies sufficiently close to each other, it is possible to use linear interpolation between the nodal points of $\omega$. A special processor can be connected to the system to measure the frequency and to calculate a new set of gain vectors if changes of the prescribed magnitude have occurred. If it is suitable, the last step can also be a part of the initialization procedure.

In this connection it is also of interest to investigate after how many cycles L(t) can be considered to be stationary. It can be shown that the deviation is less than $10^{-3}$ after 5 cycles for $\lambda = 0.98$ and 50 samplings per cycle, i.e. altogether 750 sampling instants. For $\lambda = 0.95$, which corresponds to 3 cycles, in total 450 sampling instants must be saved for each frequency. If the computer memory is not sufficient to save the gain vector for a high value of $\lambda$, it will be necessary to successively update the covariance matrix P(t) according to (10) and to compute L(t) from (20). However, the amount of computations increases considerably and for such an implementation, of course, a lower sampling frequency must be chosen.

When the regressive vector is formed, $\cos(n\omega_0 t)$ and $\sin(n\omega_0 t)$ must be evaluated. As in the case of the gain vector, this can be performed either via linear interpolation in a table or by using a fast algorithm for trigonometric functions. The first alternative is, of course, the fastest and should thus be chosen if sufficient data memory is available to store the tables.

Another important property of the regressive vector (5) proves to be that the updating of the covariance matrix is independent of the signal to which the estimator is applied. This fact makes it possible to limit the handling to one gain vector. When applying the algorithm to a three-phase system, the parameters in the different phases can then be updated according to

$$\widehat{\theta}_x(t) = \widehat{\theta}_x(t-1) + L(t) [x(t) - \widehat{\theta^T}(t-1)\,\phi(t)] \qquad (47)$$

where $x = I_A, I_B, I_C, U_A, U_B, U_C$, respectively.

In the following preferred embodiments of the invention will be described:

Figure 2 shows roughly how, in principle, the building blocks in the frequency determining part of a frequency relay are connected, purely from the functional point of view. The figure is thus a somewhat more detailed specification of the blocks 3,4,5 and 6 from Figure 1.

The incoming, filtered and sampled measurement signal y(t) is supplied to a building block or module 7 comprising an identification algorithm, and to a module 4 comprising the model in question. The identification algorithm which comprises the equations (17) ... (22) is used to produce numerical values of the parameters in the given model according to equation (2) and the processed signal. As will have been clear from the foregoing description, the combination of the given model and the identification algorithm assumes that the fundamental frequency is known with high accuracy. It is therefore necessary, according to the invention, to connect an estimator 8 for estimation of the frequency. The frequency estimator, which is based on the equations (34), (35) and (36), is supplied with the numerical values from the identification algorithm, and by cooperation with the model, the model frequency is successively adjusted to the variations in the frequency of the studied signal.

The regressive vector according to equation (5) is, in principle, generated in module 9 at each sampling instant to constitute an input quantity to the identification algorithm.

The event handling according to module 10 comprises the study of the transient process after a rapid and sufficiently great change in the system dynamics with the aid of the loss function defined according to equation (8).

As soon as the value of the loss function exceeds a certain value, the parameter estimation algorithm is re-initialized via module 11 and equations (21) and (22).

10

Fed-out quantities via module 12 consist of the estimation vector $\hat{\theta}$ and the estimated fundamental frequency $\hat{\omega}$ or $\hat{f}$.

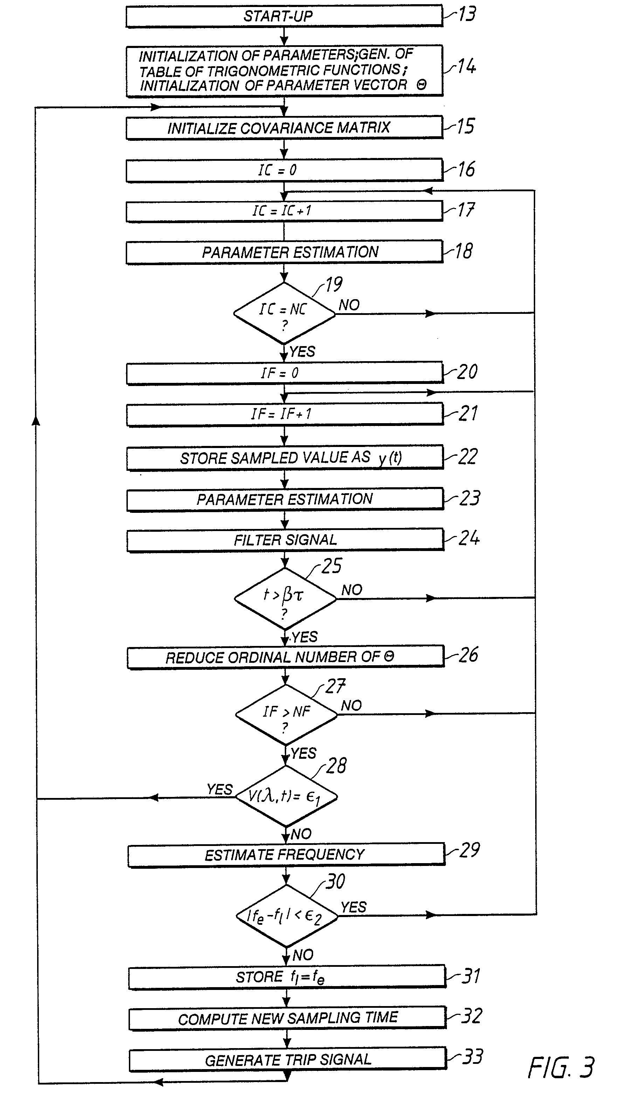

Figure 3 illustrates roughly a flow chart of how the algorithm for the frequency estimation can be implemented. All the quantities included are assumed to be represented as a fixed point number with 15 bits and one bit for the sign. When implementing the algorithm, due account is taken of the fact that the variables are of different orders of magnitude by choosing scale factors during the arithmetical operations.

The task and function of the different blocks are clear from Figure 3 as well as from the following description of the blocks:

Block 13 comprises a starting function.

Block 14 comprises

    (i) initialization of the following parameters:

$\lambda$     forgetting factor

$n_f$     number of harmonic components

$n_s$     number of samples per cycle

$n_p$     number of cycles to be stored

$f_l$     last approved estimated frequency

$t_s$     sampling time

p     pointer to pre-computed gain vector

$\delta$     initialization parameter for covariance matrix

KC     number of samples to be used to start up covariance matrix and stabilization of the parameter vector, standard setting = 20

NF     number of samples to be moved after re-start of parameter estimator before frequency estimator is switched in, standard setting = 20

    (ii) generation of a table of trigonometric functions over a quarter cycle.

    (iii) initialization of the parameter vector $\theta$. If no advance information of the system exists, all elements are set equal to zero.

Block 15 comprises initialization of the covariance matrix as $P(0) = I/\delta$, where I, as mentioned before, is a unit vector.

Block 16 comprises resetting of the initialization counter.

Block 17 comprises adjusting the initialization counter upwards at each sampling during start-up of the covariance matrix.

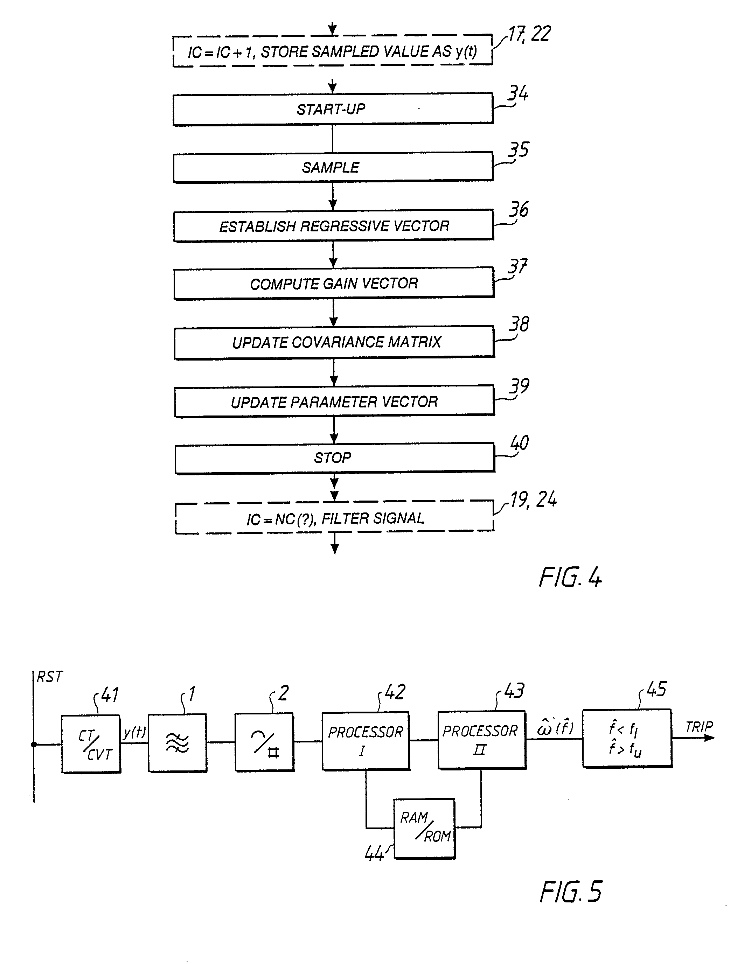

Block 18 comprises parameter estimation according to Figure 4.

Block 19 ensure that the start-up of parameter estimator proceeds for NC samples.

Block 20 comprises resetting of the frequency updating counter.

Block 21 comprises adjusting the frequency counter upwards.

Block 22 comprises storage of the last sampled value of the signal as y(t), as is clear from the figure.

Block 23 comprises, in the same way as block 18, parameter estimation according to Figure 4.

Block 24 comprises filtering of the signal by the estimated parameters according to (14). A window of the last three filtered signal values is stored in the memory to be used during the frequency estimation.

Block 25 checks whether the time t from the last initialization of the parameter estimation is great in relation to the time constant $\tau$ of the exponential term.

Block 26 reduces the number of estimated parameters when the exponential term has decayed.

Block 27 ensures that the frequency is held constant during the first NF updatings after an initialization.

Block 28 checks whether $V(\lambda,t)$ has a large amplitude. If V exceeds a certain value $\epsilon_1$, an abrupt change in the signal has occurred, which justifies carrying out an immediate restart of the parameter estimator.

Block 29 comprises producing an estimated value of the frequency according to (34).

Block 30: If the estimated frequency $f_e$ at a given sampling instant deviates by more than $\epsilon_2$ from the last approved estimate of the frequency, the latter is updated by the former. Otherwise, the next sample is carried out immediately.

Block 31 stores the computed frequency if it deviates to a sufficient extent from the immediately preceding accepted frequency estimation.

Block 32 computes a new sampling time $t_s = (n_s \cdot f_L)^{-1}$ so that the number of samplings per cycle is constant.

Block 33 generates a tripping signal as output quantity form the protective relay.

A more detailed description of the parameter estimation according to blocks 18 and 23 is clear from Figure 4 wherein

block 34, i.e. "START-UP", means that the parameter estimator is to be initialized,

block 35 means that the next sample value form the A/D converter is read,

block 36 comprises the formation of the regressive vector. Linear interpolation between the nodal points is used when the argument deviates too much from the nodal points. Trigonometric relationships are utilized to calculate regressors which correspond to harmonics,

block 37 comprises calculation of the gain vector L(t) according to equation (20),

block 38 updates the covariance matrix P(t) according to equation (19),

block 39 updates the estimation vector $\theta(n)$ according to equations (15) and (16) and updates the loss function $V(\lambda,t)$ as equation (8), and

block 40 stops the parameter estimator.

The embodiments described so far have substantially comprised the functional part of the frequency measurement part of a frequency relay according to the invention. Figure 5 illustrates an electrical/physical structure of the frequency relay. To the monitored network RST there is connected either a current transformer, CT, or a capacitive voltage transformer CVT, designated as 41. As in Figure I, Figure 5 comprises an analog filter 1 and an analog-to-digital converter 2. The A/D converter 2 digitizes the analog signal upon a call from a first microprocessor I, 42. In this connection, it is sufficient with a resolution of 12 bits.

The described algorithms for frequency and parameter estimation can be implemented with the aid of the above-mentioned first microprocessor 42 and a second microprocessor II, 43. One of these may advantageously be a signal processor. The processors are working towards a common RAM/ROM memory 44. The execution of the processors is performed simultaneously. In processor I the parameters estimator is implemented in accordance with equations (17) ... (22) and (10). Processor II is used to estimate the frequency according to equation (34) while at the same time the updating of the parameters takes place in processor I. This means that the execution in processor II is time-displaced by one sampling interval compared with processor I. Also logic handling and initialization of the algorithms are carried out in processor II.

The implementation of the various algorithms can, of course, be carried out in a many different ways depending on the available hardware and the invention is therefore not restricted to the described realization as shown in the figures.

The estimated frequency $\hat{\omega}$ or $\hat{f}$ obtained is then compared in a conventional manner in a comparator 45 with the lower permissible limiting frequency $f_l$ and the corresponding upper frequency $f_u$ and a TRIP signal is obtained when any of the limits is exceeded.

If the frequency estimation is to be carried out in a three-phase system, the availability of the three measurement signals should be utilized so that the frequency estimation works towards the first voltage in the order R,S,T, which is not zero. This can be performed by studying the Fourier coefficients for the voltages which are obtained with parameter estimators for the different phases. Only one generation for the regressive vector is necessary since it can be used for all the parameter estimators. The computation of the gain vector is carried out in a separate processor. One processor for each phase is used for the parameter estimation and the logic handling. This means that tow estimation vectors are updated in each processor. A supervisory processor is used for administration.

## Claims

1. Method for operating a frequency relay which is used for protecting objects in a power network which are sensitive to frequency variations, said frequency relay receiving as an input signal, via current or voltage transformers connected to the power network an analog measurement signal y(t) containing information about the frequencies occurring in the power network, said frequency relay further being designed to deliver an output signal when the frequency (f) of the network drifts out of a given frequency range, the method comprising a sampling and digitizing of the measurement signal, a model generation of the measurement signal in the form of a truncated Fourier series and an exponential part as well as a recursive least squares estimation method, **characterized** in that the recursive least squares estimation methodology is used for estimation of the parameters in the model of the measurement signal, that the frequency in question is computed with the aid of a number of model values consecutively filtered and sampled from the model, and that the value of the frequency thus computed is consecutively supplied to the recursive least squares estimation methodology and is used as a base for the parameter estimation and the frequency computation.

2. Method according to Claim 1, **characterized** in that the frequency $\hat{\omega}$ of the model is computed with the aid of three sampled, filtered and consecutive model values $y_1, y_2$ and $y_3$, which are separated by a time interval h in accordance with the following equation

$$\hat{\omega} = h^{-1} \ arc \ cos \ \frac{y_1 + y_2}{2y_3}. \qquad (37)$$

3. Method according to Claim 1, **characterized** in that the frequency $\omega$ of the model is computed with the aid of four sampled, filtered and consecutive model values $y_1, y_2, y_3$ and $y_4$, which are separated by a time interval h according to the following equation

$\omega = h^{-1} \cdot (arc \ sin(d) - arc \ sin(c))$ (44)

and that the phase angle $\phi$ is estimated as

$\phi = arc \ sin(c) - \omega h = 2 arc \ sin(c) - arc \ sin(d)$ (45)

wherein

$$c = \hat{b}^{-1}\left[y_2(\hat{b}-y_1^2)^{1/2} - y_1(\hat{b}-y_2^2)^{1/2}\right] \qquad (46a)$$

$$d = \hat{b}^{-1}\left[y_4(\hat{b}-y_3^2)^{1/2} - y_3(\hat{b}-y_4^2)^{1/2}\right] \qquad (46b)$$

$$b = \left[\frac{4y_2}{y_1+2y_2+y_3}\right] \cdot \left[\frac{y_1 y_3 - y_2^2}{y_1 - 2y_2 + y_3}\right] \cdot y_2 \qquad (32)$$

4. Frequency relay for carrying out the method according to any of the preceding claims, which frequency relay, via current or voltage transformers (41) connected to the power network, is adapted to receive as input signal an analog measurement signal (y(t)) containing information about the currently prevailing frequency of the power network, the frequency relay further being designed to deliver an output signal (TRIP) when the frequency (f) of the network is found to lie outside a given frequency range, **characterized** in that the frequency relay comprises an analog filtering device (1), an analog-to digital converter (2), microprocessors (42,43) for data processing in connection with a model generation of the measurement signal, estimation of the parameters of the model and estimation of the currently prevailing frequency based on model values and other event handling of the data processing, a RAM/ROM memory (44) and a comparison device (45) adapted to evaluate whether the computed frequency (f) lies within permissible limits, i.e. is greater than a lower limiting frequency ($f_l$) or smaller than an upper limiting frequency ($f_u$), and to deliver a TRIP signal when these limits are exceeded.

June 10, 1988
22 050 PE

FREQUENCY ESTIMATOR

6

$\hat{\omega}$

SYSTEM
PARAMETERS

$y(t)$

PARAMETER ESTIMATOR

3

$\hat{y}(t)$

1

2

MODEL

4

ESTIMATION
METHOD

5

*FIG. 1*

$y(t)$

IDENTIFICATION ALGORITHM
(17) - - - - (22)

7

MODEL
(2)

4

FREQUENCY ESTIMATOR
(34) (35) (36)

8

$\hat{y}(t)$

GENERATION OF REGR.
VECTOR        (5)

9

EVENT HANDLING
(8)

10

INITIALIZATION PROCEDURE
(21) (22)

11

FEED OUT

12

$\hat{\Theta}$        $\hat{\omega}, \hat{f}$

*FIG. 2*

June 10, 1988
22 050 PE

```
                    ┌──────────────────────────────────┐
                    │           START-UP               │──13
                    └──────────────────┬───────────────┘
                    ┌──────────────────┴───────────────┐
                    │ INITIALIZATION OF PARAMETERS;GEN. OF │
                    │ TABLE OF TRIGONOMETRIC FUNCTIONS ;  │──14
                    │ INITIALIZATION OF PARAMETER VECTOR Θ │
                    └──────────────────┬───────────────┘
                    ┌──────────────────┴───────────────┐
                    │    INITIALIZE COVARIANCE MATRIX   │──15
                    └──────────────────┬───────────────┘
                    ┌──────────────────┴───────────────┐
                    │              IC = 0               │──16
                    └──────────────────┬───────────────┘
                    ┌──────────────────┴───────────────┐
                    │            IC = IC + 1            │──17
                    └──────────────────┬───────────────┘
                    ┌──────────────────┴───────────────┐
                    │        PARAMETER ESTIMATION       │──18
                    └──────────────────┬───────────────┘
                              ╱─────────╲
                             ╱  IC = NC   ╲  NO
                             ╲     ?      ╱────────►
                              ╲─────────╱  19
                                  │ YES
                    ┌──────────────────┴───────────────┐
                    │              IF = 0               │──20
                    └──────────────────┬───────────────┘
                    ┌──────────────────┴───────────────┐
                    │            IF = IF + 1            │──21
                    └──────────────────┬───────────────┘
                    ┌──────────────────┴───────────────┐
                    │     STORE SAMPLED VALUE AS  y(t)  │──22
                    └──────────────────┬───────────────┘
                    ┌──────────────────┴───────────────┐
                    │        PARAMETER ESTIMATION       │──23
                    └──────────────────┬───────────────┘
                    ┌──────────────────┴───────────────┐
                    │           FILTER SIGNAL           │──24
                    └──────────────────┬───────────────┘
                              ╱─────────╲
                             ╱  t > βτ    ╲  NO
                             ╲     ?      ╱────────►
                              ╲─────────╱  25
                                  │ YES
                    ┌──────────────────┴───────────────┐
                    │    REDUCE ORDINAL NUMBER OF Θ     │──26
                    └──────────────────┬───────────────┘
                              ╱─────────╲
                             ╱  IF > NF   ╲  NO
                             ╲     ?      ╱────────►
                              ╲─────────╱  27
                                  │ YES
                              ╱─────────╲
                     YES     ╱ V(λ,t)= ε₁ ╲
                    ◄────────╲            ╱  28
                              ╲─────────╱
                                  │ NO
                    ┌──────────────────┴───────────────┐
                    │        ESTIMATE FREQUENCY         │──29
                    └──────────────────┬───────────────┘
                              ╱─────────╲
                             ╱ |fe-fl| < ε₂ ╲  YES
                             ╲            ╱────────►
                              ╲─────────╱  30
                                  │ NO
                    ┌──────────────────┴───────────────┐
                    │           STORE  fl = fe          │──31
                    └──────────────────┬───────────────┘
                    ┌──────────────────┴───────────────┐
                    │     COMPUTE NEW SAMPLING TIME     │──32
                    └──────────────────┬───────────────┘
                    ┌──────────────────┴───────────────┐
                    │        GENERATE TRIP SIGNAL       │──33
                    └──────────────────────────────────┘
```

FIG. 3

```
          ┌──────────────────────────────────────────┐ ⌐17, 22
          ╎ IC = IC + 1, STORE SAMPLED VALUE AS y(t) ╎
          └──────────────────────────────────────────┘
                              │
          ┌──────────────────────────────────────────┐  ⌐34
          │              START-UP                    │
          └──────────────────────────────────────────┘
                              │
          ┌──────────────────────────────────────────┐  ⌐35
          │               SAMPLE                     │
          └──────────────────────────────────────────┘
                              │
          ┌──────────────────────────────────────────┐  ⌐36
          │      ESTABLISH REGRESSIVE VECTOR         │
          └──────────────────────────────────────────┘
                              │
          ┌──────────────────────────────────────────┐  ⌐37
          │         COMPUTE GAIN VECTOR              │
          └──────────────────────────────────────────┘
                              │
          ┌──────────────────────────────────────────┐  ⌐38
          │       UPDATE COVARIANCE MATRIX           │
          └──────────────────────────────────────────┘
                              │
          ┌──────────────────────────────────────────┐  ⌐39
          │        UPDATE PARAMETER VECTOR           │
          └──────────────────────────────────────────┘
                              │
          ┌──────────────────────────────────────────┐  ⌐40
          │                STOP                      │
          └──────────────────────────────────────────┘
                              │
          ┌──────────────────────────────────────────┐ ⌐19, 24
          ╎        IC = NC(?), FILTER SIGNAL         ╎
          └──────────────────────────────────────────┘
                              │
                              ▼
```

FIG. 4

```
 RST
  │    ⌐41          ⌐1         ⌐2        ⌐42          ⌐43                      ⌐45
  │  ┌─────┐ y(t) ┌─────┐  ┌─────┐  ┌──────────┐ ┌──────────┐  ω̂(f̂)  ┌──────────┐  TRIP
  ●──│ CT  │──────│  ≈  │──│  ╱# │──│PROCESSOR │─│PROCESSOR │────────│ f̂ < f_l │──────▶
     │ CVT │      └─────┘  └─────┘  │    I     │ │    II    │        │ f̂ > f_u │
     └─────┘                       └──────────┘ └──────────┘        └──────────┘
                                        │          │
                                        │  ┌────────┐
                                        └──│ RAM    │
                                           │ ROM    │
                                           └────────┘
                                      44⌐
```

FIG. 5

## DOCUMENTS CONSIDERED TO BE RELEVANT

| Category | Citation of document with indication, where appropriate, of relevant passages | Relevant to claim | CLASSIFICATION OF THE APPLICATION (Int. Cl 4) |
|---|---|---|---|
| A | IEEE Trans. on Power Apparatus and Systems, vol. PAS-103, no. 10, October 1983, p. 2943-2951, Girgis et al: "Optimal Estimation of ...", especially p. 2944 | 1-4 | G 01 R 23/15 |
| | --- | | |
| A | Automatica, vol. 12, 1976, p. 601-611, Willsky: "A Survey of Design Methods for ..." | 1-4 | |
| | --- | | |
| A | IEEE Trans. on Acoustics, Speech and Signal Processing, vol. ASSP-31, June 1983, p. 521-535, Basseville et al: Design and Comparative Study of ..." | 1-4 | |

TECHNICAL FIELDS SEARCHED (Int. Cl.4)

G 01 R

The present search report has been drawn up for all claims

| Place of search | Date of completion of the search | Examiner |
|---|---|---|
| STOCKHOLM | 26-08-1988 | WIRLEE S. |